(19) Europäisches Patentamt
European Patent Office
Office européen des brevets

(11) **EP 2 530 493 B1**

(12) **FASCICULE DE BREVET EUROPEEN**

(45) Date de publication et mention
de la délivrance du brevet:
**18.03.2015   Bulletin 2015/12**

(51) Int Cl.:
***G01V 11/00*** *(2006.01)*   ***E21B 41/00*** *(2006.01)*

(21) Numéro de dépôt: **12003419.4**

(22) Date de dépôt: **03.05.2012**

(54) **Méthode pour construire un maillage d'un réseau de fractures à partir de diagramme de voronoi**

Methode zur Erstellung eines Gitternetzes eines Frakturnetzes mit Hilfe eines Voronoi-Diagramms

Method for building a fracture network mesh from a Voronoi diagram

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **01.06.2011  FR 1101686**

(43) Date de publication de la demande:
**05.12.2012   Bulletin 2012/49**

(73) Titulaire: **IFP Energies nouvelles**
**92852 Rueil-Malmaison Cedex (FR)**

(72) Inventeurs:
• **Khvoenkova, Nina**
  **92500 Rueil-Malmaison (FR)**
• **Delorme, Matthieu**
  **92500 Rueil-Malmaison (FR)**

(56) Documents cités:
**WO-A1-00/79423          WO-A1-2008/150325**
**US-A1- 2009 299 714**

• **BRANETS L.V., S.S. GHAI,, S.L. LYONS, X.-H. WU: "Efficient and Accurate Reservoir Modeling Using Adaptive Gridding With Global Scale Up", SPE 118946, 2 février 2009 (2009-02-02), - 4 février 2009 (2009-02-04), XP002667795, Texas, USA**

## Description

La présente invention concerne le domaine de l'exploitation de gisements souterrains, tels que des gisements d'hydrocarbures comportant un réseau de fractures.

En particulier, l'invention concerne une méthode pour construire un maillage du réseau de fractures et ainsi construire une image du gisement. L'invention concerne également une méthode utilisant cette image pour optimiser la gestion d'une telle exploitation au moyen d'une prédiction des écoulements de fluides susceptibles de se produire à travers ce milieu, pour simuler une production d'hydrocarbures suivant divers scénarios de production.

L'industrie pétrolière, et plus précisément l'exploration et l'exploitation de gisements, notamment pétroliers, nécessitent d'acquérir une connaissance aussi parfaite que possible de la géologie souterraine pour fournir de façon efficace une évaluation des réserves, une modélisation de la production, ou la gestion de l'exploitation. En effet, la détermination de l'emplacement d'un puits de production ou d'un puits d'injection, la constitution de la boue de forage, les caractéristiques de complétion, le choix d'un procédé de récupération des hydrocarbures (tel que l'injection d'eau par exemple) et des paramètres nécessaires à la mise en oeuvre de ce procédé (tels que la pression d'injection, le débit de production,...) nécessitent de bien connaître le gisement. Connaître le gisement signifie notamment connaître les propriétés pétrophysiques du sous-sol en tout point de l'espace, et pouvoir y prévoir les écoulements susceptibles de s'y produire.

Pour ce faire, depuis longtemps, l'industrie pétrolière allie les mesures sur champ (in situ) aux modélisations expérimentales (réalisées au laboratoire) et/ou numériques (réalisées au moyen de logiciels). Les modélisations des gisements pétroliers constituent donc une étape technique indispensable à toute exploration ou exploitation de gisement. Ces modélisations ont pour but de fournir une description du gisement.

Les réservoirs fracturés constituent un type extrême de réservoirs hétérogènes comportant deux milieux contrastés, un milieu matriciel contenant la plus grande part de l'huile en place et présentant une faible perméabilité, et un milieu fracturé représentant moins de 1 % de l'huile en place et hautement conducteur. Le milieu fracturé lui-même peut être complexe, avec différents ensembles de fractures caractérisés par leur densité, longueur, orientation, inclinaison et ouverture respectives. Le milieu fracturé est l'ensemble des fractures. Le milieu matriciel est l'ensemble de la roche autours du milieu fracturé.

Les spécialistes en charge de l'exploitation de réservoirs fracturés, ont besoin de parfaitement connaître le rôle des fractures. On appelle *"fracture"*, une discontinuité plane, de très faible épaisseur par rapport à son extension, et qui représente un plan de rupture d'une roche du gisement. D'une part, la connaissance de la distribution et du comportement de ces fractures permet d'optimiser la localisation et l'espacement entre les puits que l'on compte forer au travers du gisement pétrolifère. D'autre part, la géométrie du réseau de fractures conditionne le déplacement des fluides tant à l'échelle du réservoir qu'à l'échelle locale où elle détermine des blocs matriciels élémentaires dans lesquels l'huile est piégée. Connaître la distribution des fractures, est donc très utile, aussi, à un stade ultérieur, pour l'ingénieur de réservoir qui cherche à calibrer les modèles qu'il construit pour simuler les gisements, afin d'en reproduire ou prédire les courbes de production passées ou futures. A ces fins, les spécialistes de géosciences disposent d'images tridimensionnelles des gisements, permettant de localiser un grand nombre de fractures.

Ainsi, pour reproduire ou prédire (i.e. "simuler") la production d'hydrocarbures lors de la mise en production d'un gisement suivant un scénario de production donné (caractérisé par la position des puits, la méthode de récupération, ...), le spécialiste en ingénierie de réservoir met en oeuvre un logiciel de calcul, appelé « simulateur de réservoir » (ou « simulateur d'écoulement »), qui calcule les écoulements et l'évolution des pressions au sein du réservoir représenté par le modèle de réservoir (image du réservoir). Les résultats de ces calculs lui permettent de prévoir et d'optimiser le gisement en termes de débit et/ou de quantité d'hydrocarbures récupérés. Le calcul du comportement du réservoir suivant un scénario de production donné constitue une « simulation de réservoir ».

Pour réaliser des simulations d'écoulement autour d'un puits ou à l'échelle de quelques mailles (~km$^2$) de réservoir, en prenant en compte un réseau de fractures discret géologiquement représentatif, il est nécessaire de construire un maillage du milieu matriciel (roche) et un maillage du milieu fracturé. Ce dernier doit être adapté aux hétérogénéités géométriques (localisation des failles et fractures diffuses en trois dimensions) et dynamiques, puisque le milieu fracturé est souvent bien plus conducteur de fluides que le milieu matriciel. Ces zones de simulation, si elles sont fracturées, peuvent compter jusqu'à un million de fractures, de tailles variant de un à plusieurs centaines de mètres, et de géométries très variables : pendage, azimut, forme.

Cette étape est très utile pour la calibration hydrodynamique des modèles de fractures. En effet, la discontinuité des propriétés hydrauliques (la perméabilité dominante dans les fractures et la capacité de stockage dans la matrice) amène souvent à utiliser l'approche double milieu (propriétés homogénéisées) sur des modèles réservoir (maille hectométrique). Ces modèles sont basés sur l'hypothèse que le volume élémentaire représentatif (VER) est atteint dans la maille et que la fracturation du milieu est suffisamment importante pour pouvoir appliquer les méthodes d'homogénéisation (la périodicité stochastique de fracturation est utilisée par exemple).

Dans le cadre de l'exploitation de gisements pétroliers, les méthodes discrètes de simulation d'écoulement sont utilisées, notamment, pour la mise à l'échelle des perméabilités (à l'échelle d'une cellule de réservoir) et pour les tests dynamiques (une zone d'intérêt (ZOI) de taille petite comparée à celle du réservoir). Les temps de calcul apparaissent comme primordiaux puisque le calcul est souvent effectué séquentiellement et un grand nombre de fois dans des boucles d'optimisation. Il est connu que dans le cas de fracturation dense (fractures très connectées), les méthodes -analytiques sont applicables tandis que dans le cas d'indice de connectivité faible, la simulation numérique sur un réseau discret de fractures (DFN) est nécessaire.

Le modèle numérique, c'est à dire la matrice de transmissivités relatives aux différents objets (failles diffuses, mailles du milieu matriciel) doit respecter un certain nombre de critères :

- être applicable à un nombre important de fractures (plusieurs milliers de noeuds fractures) ;

- restituer la connectivité du réseau de fractures ;

- être évolutif afin de prendre en compte tous les modèles de fractures (plusieurs échelles de fracturation, fractures désordonnées en 3D, failles étanches, propriétés dynamiques dans le temps, ...) ;

- la forme des fractures (polygones convexes plans quelconques ou ellipses) et les hétérogénéités d'intersection entre les fractures en 3D doivent être prises en compte lors du maillage plan de chacune des fractures ;

- le nombre de noeuds de simulations doit être restreint pour pouvoir utiliser un solveur numérique ;

- être rapide et peu coûteux en mémoire (utilisable sur un poste usuel et pas uniquement sur un supercalculateur).

Avec de tels besoins, les maillages classiques (éléments finis ou volumes finis) ainsi que les méthodes qui en dérivent pour une construction locale des transmissivités ne sont pas applicables à cause d'un nombre de noeuds nécessaires à la simulation trop élevé.

On connait également la technique mise en oeuvre dans le logiciel FracaFlow™ (IFP Energies nouvelles, France) qui permet de dépasser ces limites en utilisant une approche physique basée sur des solutions analytiques de problèmes d'écoulement plans. Les fractures y sont supposées contraintes par les bancs géologiques (elles les traversent entièrement) et être sub-verticales. Une fracture est dite contrainte aux bancs si elle s'interrompt sur des changements de banc géologique. Ces hypothèses assurent que toutes les intersections ont lieu sur tout plan intermédiaire parallèle aux couches géologiques. Dans le plan médian de chaque banc géologique, les noeuds sont placés sur les intersections (un point) des fractures sur le plan (un noeud matrice et un noeud fracture au même endroit). Les connexions verticales sont portées par les fractures traversant plusieurs couches et les volumes associés aux noeuds sont calculés comme l'ensemble des points (sur le plan 2D, propagé verticalement à l'épaisseur de la couche) les plus proches du noeud (dans le milieu considéré).

Cette méthode atteint ses limites lorsque les fractures ne sont pas contraintes aux bancs et/ou le pendage des fractures n'est pas vertical. Les intersections ne sont en effet plus présentes sur chaque plan intermédiaire et la connectivité verticale ne peut plus être honorée. En augmentant le nombre de plans intermédiaires, l'erreur commise peut être réduite (sans jamais être exacte dans le cas de fractures sub-horizontales) mais le nombre de noeuds augmente considérablement et dépasse les limites imposées par les solveurs.

En outre, le document "Efficient and Accurate Reservoir Modeling Using Adaptive Gridding WIth Global Scale Up", L. V. Branets et al., SPE 118946, février 2009 décrit une méthode de modélisation d'un réservoir fracturé au moyen d'une méthode basée sur l'utilisation de diagrammes de Voronoï.

Ainsi, l'objet de l'invention concerne un procédé pour optimiser l'exploitation d'un gisement de fluide traversé par un réseau de fractures, dans lequel on construit un réseau discret de fractures (DFN), et on construit sur ce réseau discret un maillage permettant de s'affranchir des limites des méthodes antérieures et prendre en compte les fractures qui ne sont pas forcément contraintes aux bancs et les fractures sub-horizontales (comme dans certains matériaux tels que le granite), tout en limitant le nombre de mailles. Pour y parvenir, l'invention est basée sur l'utilisation de diagramme de Voronoï sur chaque plan dé fracture, afin de construire un maillage du milieu fracturé qui donne une bonne estimation des volumes en présence à chaque noeud et des lignes de courant représentant le déplacement des fluides de noeuds à noeuds.

Un avantage de l'invention est de permettre de résoudre analytiquement, à l'aide du diagramme de Voronoï, le système d'écoulements dans chaque plan de fractures, au lieu d'utiliser, comme dans les techniques antérieures, des éléments finis dans chaque plan. En effet, ces dernières techniques conduisent à des systèmes d'écoulements qui ne peuvent être résolus en conditions réelles de gisement fracturés, car ils possèdent 10000 à 100 000 noeuds sur chaque fracture. En revanche, selon l'invention, les maillages ne comportent que 3 ou 4 noeuds aux intersections, permettant de traiter des millions de fractures contrairement aux autres méthodes. L'optimisation de l'exploitation du gisement est donc possible.

**La méthode selon l'invention**

De façon générale, l'invention concerne un procédé pour optimiser l'exploitation d'un gisement de fluide traversé par un réseau de fractures, dans lequel on discrétise ledit gisement en un ensemble de mailles, on construit en chaque maille à partir d'observations dudit gisement un réseau discret de fractures (DFN) dans lequel chaque fracture est représentée par un plan fini polygonal isotrope du point de vue de ses propriétés dynamiques, ledit plan pouvant comporter au moins un segment d'intersection correspondant à une intersection entre ladite fracture et une autre fracture dudit réseau. Le procédé comporte les étapes suivantes :

a) on construit un diagramme de Voronoï sur chaque plan de fracture en positionnant des centres de cellules de Voronoï sur lesdits segments d'intersection ;

b) on calcule des transmissivités entre des centres de cellules voisines à partir du rapport entre la surface des cellules voisines et la distance entre les cellules voisines ;

c) on utilise lesdites cellules et les dites transmissivités pour construire une image du gisement de fluide ;

d) on utilise ladite image du gisement de fluide et un simulateur d'écoulement pour optimiser l'exploitation dudit gisement de fluide.

Selon l'invention, on peut positionner les centres de cellules de Voronoï sur les segments d'intersection, en appliquant la règle suivante : chaque segment d'intersection est au moins discrétisé par deux noeuds intermédiaires de Voronoï à chacune des extrémités du segment, et raffiné dans le cas de segments proches et de segments qui se croisent.

On peut limiter le nombre de cellules en procédant à un assemblage des cellules de Voronoï appartenant à un même segment d'intersection, tant que la cellule issue de l'assemblage reste connexe. Dans ce cas, la transmissivité entre deux cellules issues de l'assemblage est égale à la somme des transmissivités via les frontières les séparant selon la conservation du flux.

D'autres caractéristiques et avantages de la méthode selon l'invention, apparaîtront à la lecture de la description ci-après d'exemples non limitatifs de réalisations, en se référant aux figures annexées et décrites ci-après.

**Présentation succincte des figures**

- La figure 1 illustre les différentes étapes de la méthode selon l'invention.

- La figure 2 illustre une réalisation d'un réseau de fractures/failles à l'échelle d'un réservoir

- La figure 3 illustre un réseau de fracture discret (DFN)

- La figure 4 illustre un exemple de plan de fracture composé de six sommets et quatre segments d'intersection coplanaires dont une intersection multiple.

- La figure 5 illustre la création des centres de cellules de Voronoï pour l'exemple choisi (figure 4), selon le théorème de Koëbe.

- La figure 6 illustre la construction, à partir de la figure 5, du diagramme de Voronoï infini, avec détermination des frontières et des cellules voisines.

- La figure 7 illustre le résultat du «clipping» appliqué à l'image de la figure 6.

- La figure 8 illustre l'assemblage des cellules de Voronoï pour créer les «noeuds fracture» (ici six «noeuds fractures» caractérisés chacun par une couleur).

- La figure 9 illustre l'assemblage des cellules de Voronoï dans le cas où le « noeud fracture » ne correspond pas aux noeuds de Voronoï, avec calcul d'une correction de l'ensemble des transmissivités.

**Description détaillée de la méthode**

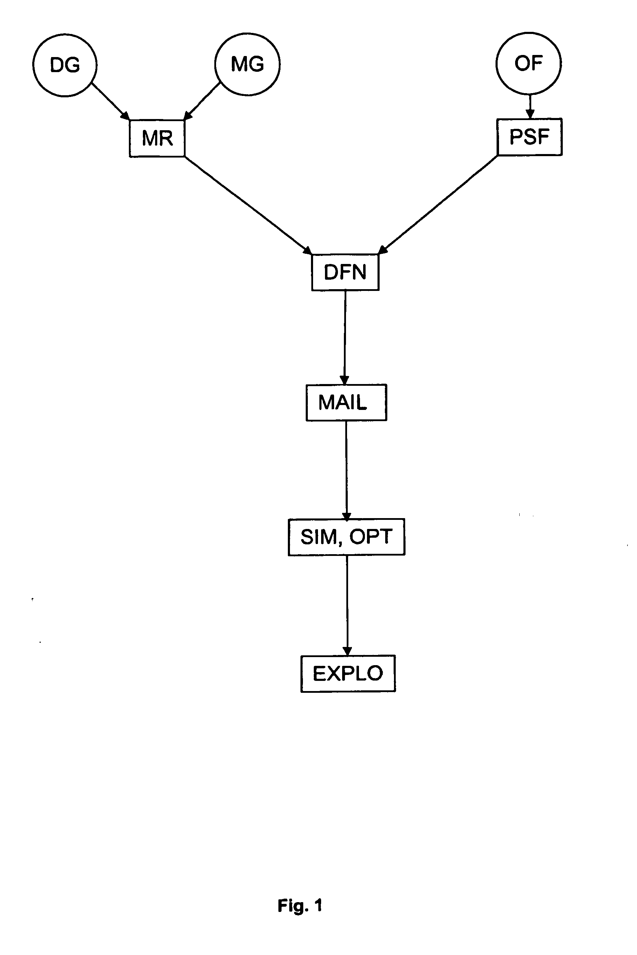

La méthode selon l'invention pour optimiser l'exploitation d'un gisement, utilisant la méthode selon l'invention de construction d'un maillage du réseau de fractures, comporte cinq étapes, les quatre premières étant mises en oeuvre par un ordinateur, comme illustré sur la figure 1 :

1- Discrétisation du gisement en un ensemble de mailles **(MR)**

2- Modélisation du réseau de fractures par un modèle de fracture discret **(DFN)**

3- Construction d'un maillage du modèle de fracture discret **(MAIL)**

4- Simulation des écoulements de fluides **(SIM)** et optimisation des conditions de production du gisement **(OPT)**

5- Exploitation (globale) optimisée du gisement **(EXPLO)**

1- Discrétisation du gisement en un ensemble de mailles (MR)

Depuis longtemps, l'industrie pétrolière allie les mesures sur champ (in situ) aux modélisations expérimentales (réalisées au laboratoire) et/ou numériques (réalisées au moyen de logiciels). Les modélisations des gisements pétroliers, constituent donc une étape technique indispensable à toute exploration ou exploitation de gisement. Ces modélisations ont pour but de fournir une description du gisement, caractérisée par la structure/géométrie et les propriétés pétrophysiques des dépôts ou formations géologiques qui le constituent.

Ces modélisations se basent sur une image du gisement, construite en discrétisant le gisement en un ensemble de mailles. Chacune de ces mailles représente un volume donné du gisement, et constitue un volume élémentaire du gisement. L'ensemble des mailles constitue une image discrète du gisement, appelée modèle de réservoir.

Les spécialistes connaissent de nombreux outils logiciels permettant de construire de tel modèle de réservoir, à partir de données **(DG)** et mesures **(MG)** relatives au gisement.

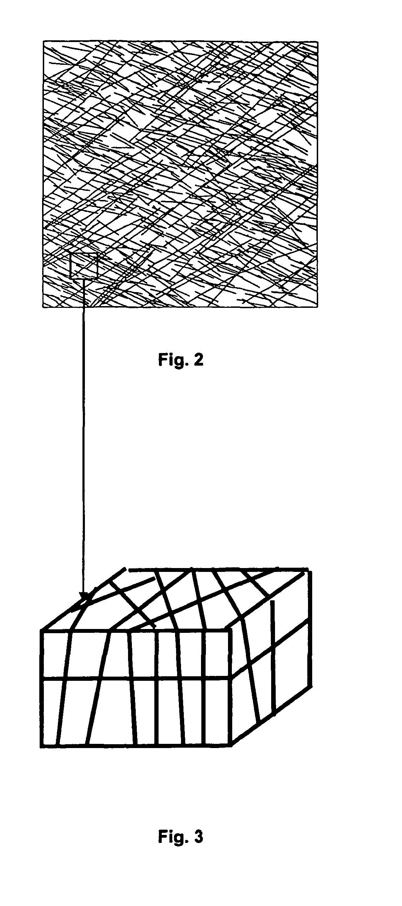

La figure 2 illustre une vue en deux dimensions d'un modèle de réservoir. Les fractures sont représentées par des lignes. Les mailles ne sont pas représentées.

### 2- Modélisation du réseau de fractures

Pour prendre en compte le rôle du réseau de fractures dans la simulation des écoulements au sein du gisement, il est nécessaire d'associer à chacun de ces volumes élémentaires (mailles du modèle de réservoir) une modélisation des fractures.

### *Caractérisation des fractures*

Les spécialistes en charge de la caractérisation statistique du réservoir, réalisent des observations (OF) directes et indirectes du réservoir. Pour cela, ils disposent 1) de carottes de puits extraites du réservoir sur lesquelles une étude statistique des fractures intersectées est effectuée, 2) d'affleurements caractéristiques du réservoir qui présentent l'avantage de fournir une vision à grande échelle du réseau de fractures 3) d'images sismiques leur permettant d'identifier de grands événements géologiques.

Ces mesures permettent de caractériser les fractures par des paramètres statistiques (PSF) : leur densité, leur longueur, leur orientation, leur inclinaison et leur ouverture respectives, et bien sur, leur distribution au sein du réservoir.

A l'issue de cette étape de caractérisation des fractures, nous disposons de paramètres statistiques (PSF) décrivant les réseaux de fractures à partir desquels des images réalistes des réseaux réels (géologiques) peuvent être reconstruites (générées) à l'échelle de chacune des mailles (cellules) du modèle de réservoir considéré (domaine de simulation).

L'objectif de la caractérisation et de la modélisation du réseau de fractures de gisement, est de proposer un modèle de fractures validé sur les écoulements locaux autour des puits. Ce modèle de fractures est alors étendu à l'échelle du réservoir afin de réaliser des simulations de production. Pour ce faire, on associe des propriétés d'écoulement à chaque maille du modèle de réservoir (MR) (tenseur de perméabilité, porosité) des deux milieux (fracture et matrice).

Ces propriétés peuvent être déterminées, soit directement à partir des paramètres statistiques (PSF) décrivant les réseaux de fractures, soit à partir d'un réseau de fracture discret (DFN) obtenus à partir des paramètres statistiques (PSF).

### *Construction d'un réseau de fracture discret (DFN) - Figure 2 et 3*

A partir d'un modèle de réservoir du gisement étudié, on lui associe en chaque maille une image détaillée (DFN) de la complexité interne du réseau de fractures aussi fidèle que possible des observations directes et indirectes du réservoir. La figure 2 illustre une réalisation d'un réseau de fractures/failles à l'échelle d'un réservoir. Chaque maille du modèle de réservoir représente ainsi un réseau discret de fractures délimitant un ensemble de blocs matriciels poreux, de formes et tailles irrégulières, délimités par des fractures. Une telle image est représentée sur la figure 3. Ce réseau de fracture discret constitue une image représentative du réseau réel de fractures délimitant les blocs matriciels.

Pour construire un réseau de fracture discret en chaque maille d'un modèle de réservoir, on peut utiliser des logiciels de modélisation, bien connus des spécialistes, tel que le logiciel FRACAFlow® (IFP Energies nouvelles, France). Ces logiciels utilisent les paramètres statistiques déterminés à l'étape de caractérisation des fractures.

Ainsi, au sein du réseau discret de fractures (DFN), chaque fracture est représentée par un plan fini polygonal isotrope du point de vue de ses propriétés. C'est-à-dire que toute propriété de la faille (dynamiques, hydrauliques telles que les transmissivités) sont homogènes sur ce plan. Ce plan peut comporter au moins un segment d'intersection correspondant à une intersection entre la fracture et une autre fracture du réseau.

### 3- Construction d'un maillage du modèle de fracture discret (MAIL)

La méthode selon l'invention permet de construire un maillage fin sur tout réseau discret de fractures 3D avec un nombre optimal de noeuds, proche du nombre d'intersections entre les fractures connectées. La connectivité du réseau de fractures discret (DFN) à l'échelle de l'étude (une zone d'intérêt de quelques milliers de mètres carrés) est respectée dans le but de simuler des écoulements. Cette méthode de maillage de chaque plan de fractures dans l'espace 3D est applicable à tous les problèmes d'écoulement dans un plan 2D avec des discontinuités au niveau des propriétés hydrauliques. Elle comporte essentiellement deux étapes :

e) on construit un diagramme de Voronoï sur chaque plan de fracture en positionnant des centres de cellules de Voronoï sur les segments d'intersection ;

f) on calcule les transmissivités entre les centres de cellules voisines à partir du rapport entre la surface des cellules voisines et la distance entre les cellules voisines.

Les cellules du maillage fracturé sont construites à partir d'un diagramme de Voronoï de segments de façon à limiter à un seul milieu homogène l'espace d'échange entre deux noeuds fracture tout en respectant localement la physique d'écoulement en milieu homogène. La discontinuité due à toute intersection de fractures est modélisée grâce à la construction du maillage. Une fois les noeuds positionnés, une formulation simple et physique est utilisée pour calculer les transmissivités : termes de liaisons entre les noeuds. Cette méthode, appliquée ici au maillage du milieu fracturé 3D, s'applique à tout problème 3D de segments d'hétérogénéités désordonnés et reliés par des plans de propriété homogène

De façon physique, nous supposons que l'intersection entre deux fractures est une hétérogénéité, l'endommagement est supposé plus grand, dans chacun des plans relatifs aux fractures respectives. Or, dans un milieu homogène, le fluide prendra le chemin nécessitant le moins d'énergie pour se déplacer d'un point à un autre. Puisque nous supposons que le gradient de pression le long de l'intersection est plus faible que dans la fracture (perméabilité plus forte), pour passer d'une intersection à une autre, le fluide emploiera le chemin de plus courte distance entre les deux segments d'intersection. Ce qui nous conduit, pour chaque fracture, à calculer le diagramme de Voronoï de segment 2D sur les intersections. Ce diagramme a en effet l'avantage de délimiter les zones d'influences de chaque fracture.

1. Le maillage du milieu fracturé est construit, sur le DFN, dans le but d'avoir le moins de noeuds possibles. Pour honorer pleinement la connectivité, les noeuds fractures sont placés sur les intersections des fractures en 3D (un ou plusieurs noeuds par segment d'intersection).

2. Les isopressions, orthogonales au gradient de pression et donc aux lignes de courant dans chaque plan de fracture homogène, sont supposées parallèles aux intersections.

3. Les cellules du maillage sont construites à partir d'un diagramme de Voronoï de segments sur chaque plan de fractures. Cette construction à l'avantage de:

- limiter à un seul milieu homogène (le plan d'une fracture) l'espace d'échange entre deux noeuds fractures,

- de respecter localement, l'orthogonalité entre la ligne de courant (entre deux noeuds) et la frontière des cellules.

- faciliter le calcul approché du gradient de pression entre les noeuds le long de la frontière.

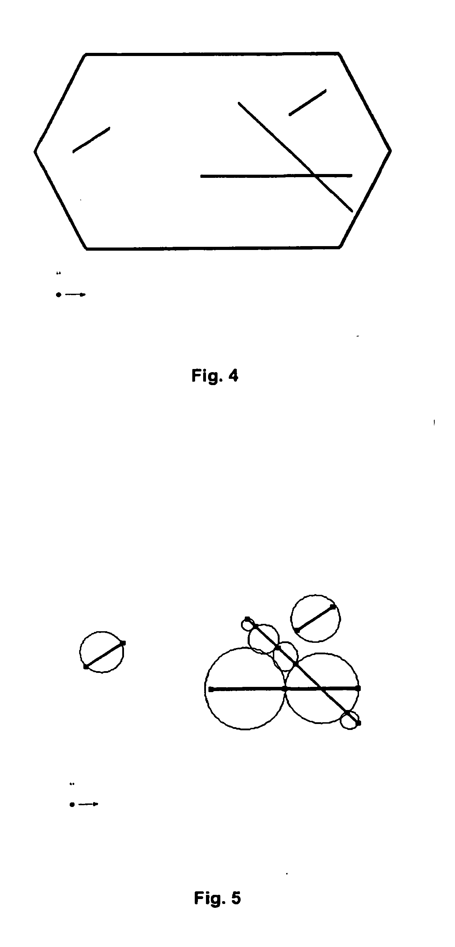

Selon l'invention, chaque fracture est représentée par un plan fini polygonal isotrope du point de vue de ses propriétés dynamiques. Chaque plan peut comporter au moins un segment d'intersection correspondant à une intersection entre ladite fracture et une autre fracture du réseau (DFN). La figure 4 illustre un exemple composé d'une fracture à six sommets et quatre segments d'intersection coplanaires dont une intersection multiple. La méthode pour mailler ce plan comporte les étapes suivantes :

1. Pour chaque intersection, création d'un noeud fracture (un noeud au centre de chaque intersection, on garde l'information sur les coordonnées des deux extrémités). Dans le cas d'une intersection multiple (trois fractures au moins s'intersectent en un même point), on remplace le noeud initial au centre du segment par deux noeuds de part et d'autre du point. Le but de ce prétraitement est d'assurer la connexité de toute maille fracture.

2. Construction du diagramme de Voronoï sur chaque plan de fracture à partir des segments d'intersection en appliquant le théorème de Koëbe. C'est à dire que chaque segment est au moins discrétisé par deux noeuds intermédiaires de Voronoï à chacune des extrémités et raffiné dans le cas de segments trop proches ou de segments qui se croisent. Cette construction peut se décomposer selon les étapes suivantes :

i. Création de l'ensemble des centres de cellules de Voronoï: points vérifiant le théorème des "Kissing disks" de Koebe-Andreev-Thurston (P. Koebe. Kontaktprobleme der konformen Abbildung. Ber. S̈achs. Akad. Wiss. Leipzig, Math.-Phys. Kl., 88:141-164, 1936.) sur chaque intersection contenue dans le plan de la fracture : chaque segment est au moins discrétisé par deux noeuds intermédiaires de Voronoï à chacune des extrémités du segment, et raffiné dans le cas segments qui se croisent et de segments trop proches (la notion de proximité dépend de la distance à partir de laquelle on estime que deux points sont confondus. Il s'agit d'un paramètre de précision géométrique que l'utilisateur peut définir en fonction de la taille du domaine d'étude par rapport à la taille des fractures notamment). La figure 5 illustre la création des centres de cellules de Voronoï pour l'exemple choisi (figure 4), selon le théorème de Koëbe. On s'assure ici que pour chaque triplet de points, le cercle dont le centre est le milieu de deux des points ne contient pas le troisième point.

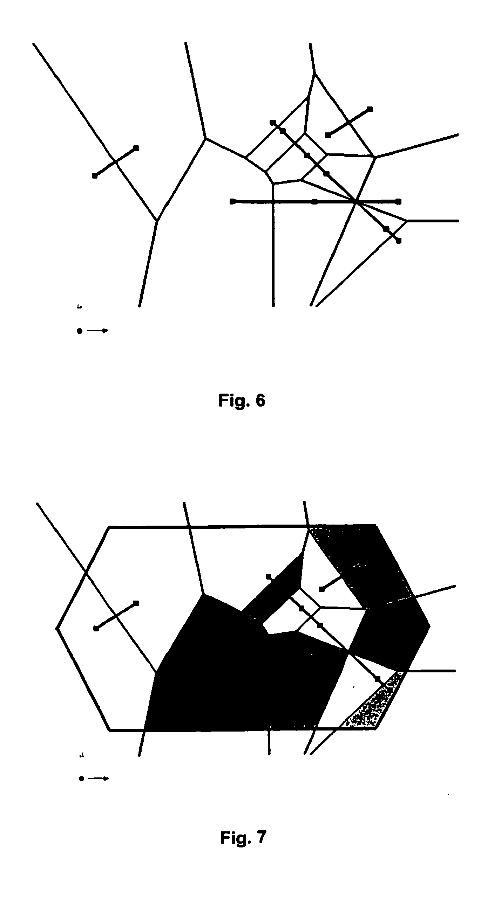

ii. Construction du diagramme de Voronoï sur ces points en utilisant l'algorithme de S.Fortune (S. J. Fortune, A sweepline algorithm for Voronoi diagrams, Algorithmica 2 (1987), 153-174.), prouvé être le plus rapide sur un plan 2D infini. La figure 6 illustre la construction du diagramme de Voronoï infini, avec détermination des frontières et des cellules voisines.

iii. « Clipping » du diagramme de Voronoï infini par rapport au polygone fini définissant la fracture. Le « clipping » désigne le fait de borner le résultat d'un visuel à un domaine donné. A ce stade, les cellules de Voronoï sont convexes et la ligne passant par les centres de deux cellules voisines est orthogonale à la frontière qui les sépare. Une telle géométrie permet d'approximer plus facilement le gradient de pression entre les noeuds le long de la frontière. La figure 7 illustre le résultat du « clipping » appliqué à l'image de la figure 6.

3. Calcul fin des transmissivités entre les centres des cellules voisines du diagramme.

On calcule les transmissivités (Tff) entre les centres de cellules voisines à partir du rapport entre la surface (Sc) des cellules voisines et la distance (Dc) entre les cellules voisines :

Tff = K.Sc/Dc     avec K, la perméabilité de la fracture dans laquelle se produit l'écoulement

4. Assemblage de cellules de Voronoï

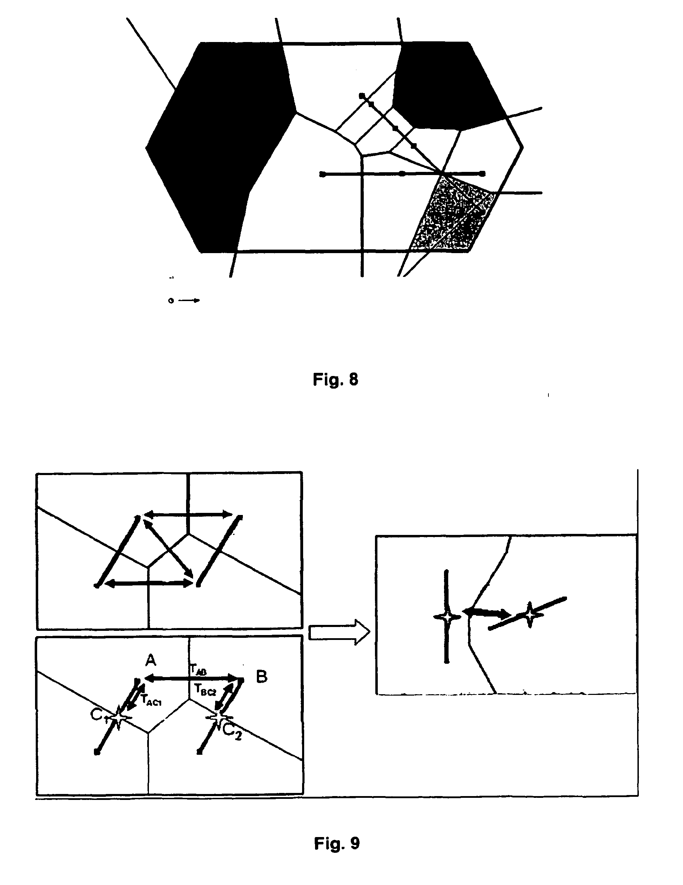

Nous supposons que l'endommagement à l'intersection entre deux fractures est plus grand que dans les plans respectifs des fractures. Il en résulte une prise en compte des discontinuités de conductivités sur le plan de fracture localement le long des intersections. Les lignes d'isopression dans chaque plan de fracture correspondent alors aux lignes d'équidistance entre les traces d'intersection. Le diagramme de Voronoï de segments répond à ce critère, les cellules de ce diagramme deviennent les mailles fractures (connexes par construction) associées au noeud. Pour limiter le nombre de noeuds nous procédons à un assemblage des cellules de Voronoï appartenant à un même segment d'intersection tant que la cellule reste connexe (c'est à dire que les cellules appartiennent au même segment et qu'il n'y a pas d'intersection multiple). La figure 8 illustre l'assemblage des cellules de Voronoï pour créer les « noeuds fracture » (ici six « noeuds fractures » caractérisés chacun par une couleur).

Ensuite, les volumes sont sommés, la transmissivité entre deux « noeuds fracture » est égale à la somme des transmissivités via les frontières les séparant selon la conservation du flux. Si un noeud fracture $A$ contient plusieurs points Voronoï $P_{Ai}$ et un noeud $B$ contient plusieurs points Voronoï $P_{Bj}$, la transmissivité entre deux noeuds fracture A et B est calculée comme la somme des transmissivités entre toutes les paires de cellules Voronoï appartenant à au noeud et ayant une face commune (figure 8).

$$T_{AB} = \sum_{i,j} T\left(P_{A_i}, T_{B_j}\right)$$

En cas d'assemblage, le « noeud fracture » ne correspondant pas aux noeuds de Voronoï, nous effectuons une correction de l'ensemble des transmissivités pour prendre en compte les modifications de distance pour les échanges de fluides. Cette modification dépend de la perméabilité affectée à chaque intersection de fractures (qui peut varier selon le modèle, de celle du plan de calcul à l'infini). On peut en effet vouloir modéliser une perméabilité différente le long de l'intersection de deux fractures, sans qu'elle soit infinie, par rapport à celle qui définit chacun des plans de fractures. Pour trouver la correction liée à la conductivité finie d'un segment d'intersection, on rajoute une transmissivité entre le centre $C1$ du noeud (ou géométriquement parlant du segment) A et un point Voronoï $P_{Ai}$. Ainsi si deux noeuds (ou plus) Voronoï appartiennent à un même noeud fracture (figure 9) de centre C1, la transmissivité $T_{S1S2}$ entre un noeud A et un noeud B est calculée comme suit:

$$T_{AB}^{corr} = \left(\frac{1}{T_{C_1 A_i}} + \frac{1}{T_{A_i B_j}} + \frac{1}{T_{C_2 B_j}}\right)^{-1}$$

Cette correction supprime l'hypothèse de conductivité infinie le long de la fracture si le choix du modèle impose $T_{C1A.} \neq 0$.
Pour être mis en oeuvre dans un logiciel et exécuté sur un ordinateur, les entrées de l'algorithme, peuvent être les suivantes :

- Zone d'intérêt: parallélépipède en 3D donné par la boite englobante (Xmin, Ymin, Zmin, Xmax, Ymax, Zmax) du domaine de simulation,

- Liste des fractures (polygones plans convexes en 3D donnés par des listes de sommets ordonnés) avec leurs propriétés hydrauliques isotropes dans chaque plan de fracture (perméabilité, épaisseur, compressibilité)

- Table de connectivité aux conditions limites (tableau indiquant à quel amas (celui de la taille maximale) appartient une fracture. Un amas est un groupement de fractures pour lesquelles il existe un chemin reliant chacun des membres)

- Liste des segments d'intersection 3D, et pour chaque fracture une liste de pointeurs vers les intersections correspondantes. Chaque intersection et sommet de fractures est exprimé, par changement de base, dans un repère local à la fracture. Ainsi, le problème général 3D est ramené en une succession de problèmes plans 2D.

Cette nouvelle technique de maillage du milieu fracturé permet de construire un maillage fin sur le réseau discret de fractures avec un nombre optimal de noeuds, proche du nombre d'intersections entre les fractures connectées.

- La connectivité du DFN à l'échelle de l'étude (une zone d'intérêt de quelques milliers de mètres carrés) est respectée dans le but de simuler des écoulements.

- Les cellules 3D du maillage fracturé sont construites à partir d'un diagramme de Voronoï de segments discrétisé selon le théorème de Koëbe sur chaque plan de fractures. Cette construction à l'avantage de:

  o limiter à un seul milieu homogène (le plan d'une fracture) l'espace d'échange entre deux noeuds fracture,

  o de respecter localement, l'orthogonalité entre la ligne de courant (entre deux noeuds) et la frontière des cellules et calculer aisément le gradient de pression entre les noeuds le long de la frontière,

  o prendre en compte la discontinuité due à toute intersection de fractures,

  o être décomposée en étapes simples, facilement parallélisables.

Cette nouvelle technique de maillage du milieu fracturé constitue donc une méthode semi-analytique utilisant un diagramme de Voronoï pour réduire le nombre de noeuds nécessaires à la simulation d'écoulements sur un réseau de fractures discrets. De ce fait, le procédé selon l'invention est applicable à des zones de calculs plus grandes que les procédés antérieurs.

Les résultats de cette méthode de maillage (les noeuds, leur volume et transmissivités associées) peuvent alors être utilisés en double milieu pour simuler des tests de puits, tests d'interférence ou un calcul de perméabilité équivalente. Cette méthode, appliquée ici au maillage du milieu fracturé 3D, s'applique à tout problème plan homogène peuplé par des segments d'hétérogénéités.

L'étape suivante consiste à déterminer les propriétés d'écoulement des fractures initiales, puis à calibrer ces propriétés au moyen de simulation de tests de puits sur des modèles d'écoulement locaux discrets, hérités de l'image réalistes du réseau réel (géologique) de fractures à l'échelle du réservoir. Bien que ne couvrant qu'une aire limitée (aire de drainage) autour du puits, un tel modèle de simulation de tests de puits comporte encore de très nombreux noeuds de calcul si le réseau de fractures est dense. En conséquence, la taille des systèmes à résoudre et/ou la durée des calculs demeurent souvent prohibitives.

4- Calibration des propriétés d'écoulement des fractures

L'étape suivante est la calibration des propriétés d'écoulement des fractures (conductivité et ouverture des fractures), localement autour des puits. Celle-ci, si nécessaire, nécessite la simulation de tests de puits.

Ce type de calibration est bien connu des spécialistes. On peut par exemple utiliser la méthode décrite dans le brevet FR 2.787.219. On simule, les réponses en écoulement de quelques puits (tests d'écoulement transitoires ou pseudo-permanents, interférences, débitmétrie, etc.) sur ces modèles extraits du modèle géologique donnant une image discrète (réaliste) des fractures alimentant ces puits. Puis, on compare le résultat de la simulation avec les mesures réelles effectuées aux puits. Si les résultats divergent, on modifie les paramètres statistiques (PSF) décrivant les réseaux de fractures, puis on redétermine les propriétés d'écoulement des fractures initiales, et on effectue une nouvelle simulation. L'opération est répétée jusqu'à ce que les résultats de simulation et les mesures convergent.

Les résultats de ces simulations permettent de calibrer (estimer) la géométrie et les propriétés d'écoulement des fractures, telles que les conductivités des réseaux de fractures du réservoir étudié et les ouvertures.

5- Simulation des écoulements de fluides **(SIM)** et optimisation des conditions de production du gisement **(OPT)**

A ce stade, l'ingénieur de réservoir dispose alors des données requises pour construire le modèle d'écoulement à l'échelle du réservoir. L'image est composée de la discrétisation du gisement en un ensemble de mailles (MR), chacune de ces mailles comportant une modélisation du réseau de fractures par un modèle discret de fracture (DFN), et chaque fracture de ce modèle de fracture discret (DFN) étant maillée par les cellules de Voronoï renseignées en transmissivités.

Les simulations de réservoir fracturé adoptent souvent l'approche "double porosité", proposée par exemple par Warren J.E. et al. dans "The Behavior of Naturally Fractured Reservoirs", SPE Journal (septembre 1963), 245-255, et selon laquelle tout volume élémentaire (maille du modèle de réservoir) du réservoir fracturé est modélisé sous la forme d'un ensemble de blocs parallélépipédiques identiques, appelés blocs équivalents, délimités par un système orthogonal de fractures uniformes continues orientées suivant les directions principales d'écoulement. L'écoulement des fluides, à l'échelle du réservoir, s'effectue à travers les fractures seulement, et des échanges de fluides interviennent localement entre les fractures et les blocs matriciels. L'ingénieur de réservoir peut par exemple utiliser les méthodes décrites dans les documents suivants, appliquées à l'ensemble du réservoir cette fois : FR 2.757.947 (US 6.023.656), FR 2.757.957 (US 6.064.944) et EP 2 037 080.

L'ingénieur réservoir choisit un procédé de production, par exemple le procédé de récupération par injection d'eau, dont il demeure ensuite à préciser le scénario optimal de mise en oeuvre pour le champ considéré. La définition d'un scénario optimal d'injection d'eau consistera, par exemple, à fixer le nombre et l'implantation (position et espacement) des puits injecteurs et producteurs afin de tenir compte au mieux de l'impact des fractures sur la progression des fluides au sein du réservoir.

En fonction du scénario choisi, de l'image double milieu du gisement, et de la formule reliant le flux d'échange de masse et/ou d'énergie à la différence de potentiel matrice-fracture, on est alors capable de simuler la production d'hydrocarbures escomptée, au moyen du simulateur d'écoulement (logiciel) dit à double milieu.

A tout instant t de la production simulée, à partir des données d'entrées E(t) (données fixes ou variables au fur et à mesure du temps simulé), et de la formule reliant le flux (f) d'échange à la différence de potentiel ($\Delta\Phi$), le simulateur résout l'ensemble des équations propres à chaque maille et chacune des deux grilles du modèle (équations faisant intervenir la formule d'échange matrice-fracture décrite plus haut) et délivre ainsi les valeurs solutions des inconnues S(t) (saturations, pressions, concentrations, température, ...) à cet instant t. De cette résolution, découle la connaissance des quantités d'huile produites et de l'état du gisement (distribution des pressions, saturations, etc.) à l'instant considéré.

6- Exploitation optimisé du gisement **(EXPLO)**

On utilise l'image du gisement de fluide et un simulateur d'écoulement pour optimiser l'exploitation dudit gisement de fluide. En sélectionnant divers scénarios, caractérisés par exemple par diverses implantations respectives des puits injecteurs et producteurs, et en simulant la production d'hydrocarbures pour chacun d'eux selon l'étape 5, on peut sélectionner le scénario permettant d'optimiser la production du gisement fracturé considéré suivant les critères technico-économiques sélectionnés.

Les spécialistes exploitent alors le gisement selon ce scénario permettant d'optimiser la production du gisement.

**Revendications**

1. Procédé pour optimiser l'exploitation d'un gisement de fluide traversé par un réseau de fractures, dans lequel on discrétise ledit gisement en un ensemble de mailles, on construit en chaque maille à partir d'observations dudit gisement un réseau discret de fractures (DFN) dans lequel chaque fracture est représentée par un plan fini polygonal isotrope du point de vue de ses propriétés dynamiques, ledit plan pouvant comporter au moins un segment d'intersection correspondant à une intersection entre ladite fracture et une autre fracture dudit réseau, **caractérisée en ce que** le procédé comporte les étapes suivantes :

   g) on construit un diagramme de Voronoï sur chaque plan de fracture en positionnant des centres de cellules de Voronoï sur lesdits segments d'intersection ;
   h) on calcule des transmissivités entre des centres de cellules voisines à partir du rapport entre la surface des cellules voisines et la distance entre les cellules voisines ;
   i) on utilise lesdites cellules et les dites transmissivités pour construire une image du gisement de fluide ;
   j) on utilise ladite image du gisement de fluide et un simulateur d'écoulement pour optimiser l'exploitation dudit gisement de fluide.

2. Procédé selon la revendication 1, dans lequel on positionne les centres de cellules de Voronoï sur lesdits segments d'intersection, en appliquant la règle suivante : chaque segment d'intersection est au moins discrétisé par deux noeuds intermédiaires de Voronoï à chacune des extrémités dudit segment, et raffiné dans le cas de segments proches et de segments qui se croisent.

3. Procédé selon l'une des revendications précédentes, dans lequel on limite le nombre de cellules en procédant à un assemblage des cellules de Voronoï appartenant à un même segment d'intersection, tant que la cellule issue de l'assemblage reste connexe.

4. Procédé selon la revendication 3, dans lequel la transmissivité entre deux cellules issues de l'assemblage est égale à la somme des transmissivités via les frontières les séparant selon la conservation du flux.

**Patentansprüche**

1. Verfahren zur Optimierung der Ausbeutung einer Fluidlagerstätte, die von Netzwerk von Klüften durchzogen ist, wobei die Lagerstätte in eine Gesamtheit einzelner Zellen untergliedert wird, in jeder der Zellen ausgehend von Beobachtungen der Lagerstätte ein Einzelnetzwerk von Klüften (DFN) geschaffen wird, in welchem jede Kluft durch eine polygonale endliche Ebene dargestellt ist, die hinsichtlich ihrer dynamischen Eigenschaften isotrop ist, wobei die Ebene mindestens einen Schnittstellenbereich aufweisen kann, welcher einer Schnittstelle der Kluft mit einer anderen Kluft des Netzwerks entspricht, **dadurch gekennzeichnet, dass** das Verfahren die folgenden Schritte aufweist:

   g) Erstellen eines Voronoi-Diagramms auf jeder Kluftebene, wobei die Zentren der Voronoi-Regionen auf den Schnittstellenbereichen angeordnet werden;
   h) Berechnen der Transmissivitätswerte zwischen den Zentren benachbarter Regionen ausgehend von dem Verhältnis zwischen der Oberfläche der benachbarten Regionen und dem Abstand zwischen den benachbarten Regionen;
   i) Verwenden der Regionen und der Transmissivitätswerte, um ein Bild der Fluidlagerstätte zu erstellen;
   j) Verwenden des Bildes der Fluidlagerstätte und eines Strömungssimulators, um die Ausbeutung der Fluidlagerstätte zu optimieren.

2. Verfahren nach Anspruch 1, wobei die Zentren der Voronoi-Regionen unter Anwendung der folgenden Regel auf den Schnittstellenbereichen angeordnet werden: jeder Schnittstellenbereich wird mindestens durch zwei zwischengelagerte Voronoi-Knoten, die sich jeweils an den Ende des Bereichs befinden, vereinzelt, wobei er im Falle von sich naheliegenden Bereichen und von sich kreuzenden Bereichen auch eine Feinbehandlung erfährt.

3. Verfahren nach einem der vorhergehenden Ansprüche, wobei die Anzahl von Regionen begrenzt wird, indem Voronoi-Regionen, die ein- und demselben Schnittstellenbereich angehören, solange zusammengefügt werden, wie die Region, welche beim Zusammenfügen entsteht, noch zusammenhängend ist.

4. Verfahren nach Anspruch 3, wobei der Transmissivitätswert zwischen zwei Regionen, die beim Zusammenfügen entstanden sind, gleich der Summe der Transmissivitätswerte ist, die gemäß der Strömungserhaltung an den Grenzen auftreten, durch welche diese getrennt werden.

**Claims**

1. A method for optimizing the development of a fluid reservoir traversed by a fracture network, comprising discretizing said reservoir into a set of cells and constructing in each cell, from observations of said reservoir, a discrete fracture network (DFN) wherein each fracture is represented by a polygonal finite plane, isotropic as regards its dynamic properties, and said plane can comprise at least one intersection segment corresponding to an intersection between said fracture and another fracture of said network, **characterized in that** the method comprises the following stages:

   a) constructing a Voronoi diagram on each fracture plane by positioning Voronoi cell centers on said intersection segments,
   b) calculating transmissivities between neighbouring cell centers from the ratio of the surface area of the neighbouring cells to the distance between the neighbouring cells,
   c) using said cells and said transmissivities for constructing an image of the fluid reservoir,
   d) using said image of the fluid reservoir and a flow simulator for optimizing the development of said fluid reservoir.

2. A method as claimed in claim 1, wherein the Voronoi cell centers are positioned on said intersection segments by applying the following rule: each intersection segment is at least discretized by two intermediate Voronoi nodes at each end of said segment, and refined in the case of close segments and intersecting segments.

3. A method as claimed in any one of the previous claims, wherein the number of cells is limited by assembling the Voronoi cells belonging to the same intersection segment, as long as the cell from the assembly remains connected.

4. A method as claimed in claim 3, wherein the transmissivity between two cells from the assembly is equal to the sum of the transmissivities via the boundaries between them according to the flux conservation.

**Fig. 1**

EP 2 530 493 B1

Fig. 2

Fig. 3

**Fig. 4**

**Fig. 5**

Fig. 6

Fig. 7

**Fig. 8**

**Fig. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2787219
- FR 2757947
- US 6023656 A
- FR 2757957
- US 6064944 A
- EP 2037080 A

**Littérature non-brevet citée dans la description**

- **L. V. BRANETS et al.** Efficient and Accurate Reservoir Modeling Using Adaptive Gridding WIth Global Scale Up. *SPE 118946,* Février 2009
- **P. KOEBE.** Kontaktprobleme der konformen Abbildung. *Ber. S̈achs. Akad. Wiss. Leipzig, Math.-Phys. Kl.,* 1936, vol. 88, 141-164
- **S. J. FORTUNE.** A sweepline algorithm for Voronoi diagrams. *Algorithmica,* 1987, vol. 2, 153-174
- **WARREN J.E. et al.** The Behavior of Naturally Fractured Reservoirs. *SPE Journal,* Septembre 1963, 245-255